# EUROPEAN PATENT APPLICATION

(11) **EP 4 780 150 A1**
(43) Date of publication of application: **22.07.2026**
(21) Application number: 24915464.2
(22) Date of filing: 31.12.2024
(51) Int. Cl.: H05K 7/20, H05K 1/14, H05K 1/02, H05K 1/11, H01L 23/373, H01L 23/427

(54) **ELECTRONIC DEVICE COMPRISING HEAT DISSIPATION MEMBER**

(30) Priority: 03.01.2024 KR 20240001174; 12.04.2024 KR 20240049182
(71) Applicant: Samsung Electronics Co., Ltd., Suwon-si, Gyeonggi-do 16677 (KR)
(72) Inventor: PARK, Min, Suwon-si Gyeonggi-do 16677 (KR); SON, Jihyeon, Suwon-si Gyeonggi-do 16677 (KR); JUNG, Jinhwan, Suwon-si Gyeonggi-do 16677 (KR); KIM, Boram, Suwon-si Gyeonggi-do 16677 (KR); NAM, Hyungjong, Suwon-si Gyeonggi-do 16677 (KR); MOON, Youngjoo, Suwon-si Gyeonggi-do 16677 (KR); YOON, Jeonggen, Suwon-si Gyeonggi-do 16677 (KR); LEE, Kyuhwan, Suwon-si Gyeonggi-do 16677 (KR); LEE, Haejin, Suwon-si Gyeonggi-do 16677 (KR); CHANG, Yoonhee, Suwon-si Gyeonggi-do 16677 (KR); HWANG, Jieun, Suwon-si Gyeonggi-do 16677 (KR)
(74) Representative: Gulde & Partner
(86) International application number: PCT/KR2024/021553
(87) International publication number: WO 2025/147054

(57) **Abstract**

The present disclosure relates to an electronic device. The electronic device according to one embodiment of the disclosure comprises: a first substrate including a first surface and a second surface oriented in the opposite direction of the first surface; a second substrate including a third surface facing the first surface, and a fourth surface oriented in the opposite direction of the third surface; at least one interposer arranged between the first surface and the third surface; a first electronic component arranged on the fourth surface; and a heat dissipation member which is solid at room temperature, and which is arranged in a space defined by the first substrate, the second substrate and the at least one interposer, so as to overlap the first electronic component when viewed in the direction perpendicular to the fourth surface.

## Description

### [Technical Field]

The disclosure relates to an electronic device, for example, an electronic device including a heat dissipation structure for electronic components.

### [Background Art]

The term "electronic device" may refer to a device that performs a specific function based on an installed program, such as a home appliance, an electronic scheduler, a portable multimedia player, a mobile communication terminal, a tablet PC, a video/audio device, a desktop/laptop PC, or a vehicle navigation system. For example, these electronic devices may output stored information as sound or images.

As the integration degree of electronic devices increases and ultra-high-speed and/or high-capacity wireless communication become more widespread, a single electronic device such as a mobile communication terminal may now be equipped with various functions. For example, not only communication functions but also entertainment functions such as gaming, multimedia functions such as music and video playback, communication, and security functions such as mobile banking, as well as schedule management and electronic wallet functions, are being integrated into a single electronic device. These electronic devices are being miniaturized to be conveniently carried by users.

### [Detailed Description of the Invention]

[Technical Solution] An electronic device according to an embodiment of the disclosure may include a first substrate including a first surface and a second surface opposite to the first surface, a second substrate including a third surface facing the first surface and a fourth surface opposite to the third surface, an interposer disposed between the first surface and the second surface, a first electronic component disposed on the fourth surface, and a heat dissipation member which is in a solid phase at room temperature and is disposed in a space defined by the first substrate, the second substrate, and the interposer so as to overlap with the first electronic component when viewed in a direction perpendicular to the fourth surface.

An electronic device according to an embodiment of the disclosure may include a first substrate including a first surface and a second surface opposite to the first surface, a second substrate including a third surface facing the first surface and a fourth surface opposite to the third surface, an interposer disposed between the first surface and the second surface, a first electronic component disposed on the second surface, and a heat dissipation member which is in a solid phase at room temperature and is disposed in a space defined by the first substrate, the second substrate, and the interposer so as to overlap with the first electronic component when viewed in a direction perpendicular to the fourth surface.

### [Brief Description of Drawings]

FIG. 1 is a block diagram illustrating an electronic device 101 in a network environment 100 according to various embodiments.
FIG. 2 is a perspective view of an electronic device according to an embodiment of the disclosure, illustrating the front surface of the electronic device.
FIG. 3 is an exploded perspective view of the electronic device according to an embodiment of the disclosure, illustrating the front surface of the electronic device.
FIG. 4 is a cross-sectional view of a substrate assembly according to an embodiment of the disclosure, taken along cut line A-A' illustrated in FIG. 3.
FIG. 5 is a plan view of a substrate assembly according to an embodiment of the disclosure.
FIG. 6 illustrates a first substrate included in the substrate assembly illustrated in FIG. 5 and components disposed on the first substrate.
FIG. 7 illustrates a second substrate included in the substrate assembly illustrated in FIG. 5 and components disposed on the second substrate.
FIG. 8 is a view illustrating the composition of a heat dissipation member according to an embodiment of the disclosure, illustrating materials included in the heat dissipation member.
FIG. 9 is a cross-sectional view of a state on which a heat dissipation member is disposed on a substrate according to an embodiment of the disclosure.
FIG. 10 is a cross-sectional view of a substrate on which a heat dissipation member is disposed according to the process illustrated in FIG. 9.
FIG. 11 is a graph showing a temperature profile in a reflow soldering process according to an embodiment of the disclosure.
FIG. 12 is a cross-sectional view illustrating a heat dissipation member in a gel phase in a soldering section illustrated in FIG. 11.
FIG. 13 is a cross-sectional view of a heat dissipation member and an adhesive member according to an embodiment of the disclosure.
FIG. 14 is a cross-sectional view illustrating a state in which a heat dissipation member is softened in a reflow soldering process according to another embodiment of the disclosure.
FIG. 15 is a cross-sectional view illustrating a state in which a substrate assembly is assembled in a soldering section of reflow soldering according to another embodiment of the disclosure.

### [Mode for Carrying out the Invention]

The following description, made with reference to the accompanying drawings, may provide an understanding of various exemplary implementations of the disclosure including the claims and equivalents thereof. An exemplary embodiment set forth in the following description includes various particular details to help the understanding, but is considered one of various exemplary embodiments. Therefore, it will be apparent to those skilled in the art that various changes and modifications may be made to various implementations described herein without departing from the scope and technical idea of the disclosure. In addition, descriptions of well-known functions and configurations may be omitted for clarity and brevity.

The terms and words used in the following description and claims are not limited to bibliographical meanings, but may be used to clearly and consistently describe the various embodiments set forth herein. Therefore, it will be apparent to those skilled in the art that the following description of various implementations of the disclosure is provided only for the purpose of explanation, rather than for the purpose of limiting the disclosure defined as the scope of protection and equivalents thereto.

It should be appreciated that a singular form such as "a," "an," or "the" also includes the meaning as a plural form, unless the context clearly indicates otherwise. Therefore, for example, "a component surface" may mean one or more of component surfaces.

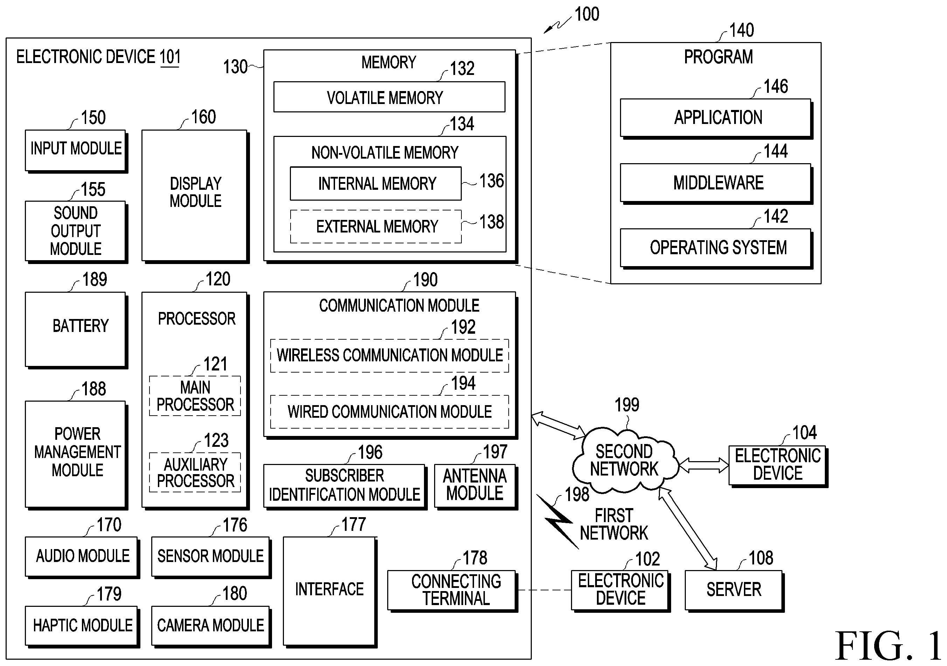

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," ***"coupled to," "connected with,"*** or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

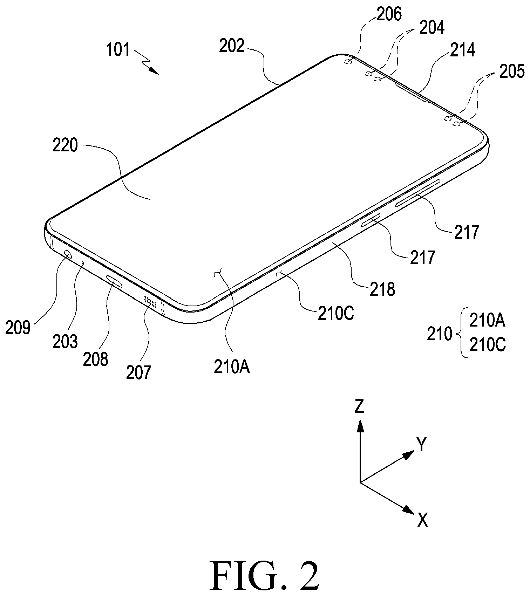

FIG. 2 is a perspective view of an electronic device 101 according to an embodiment of the disclosure, illustrating the front surface 210A of the electronic device 101.

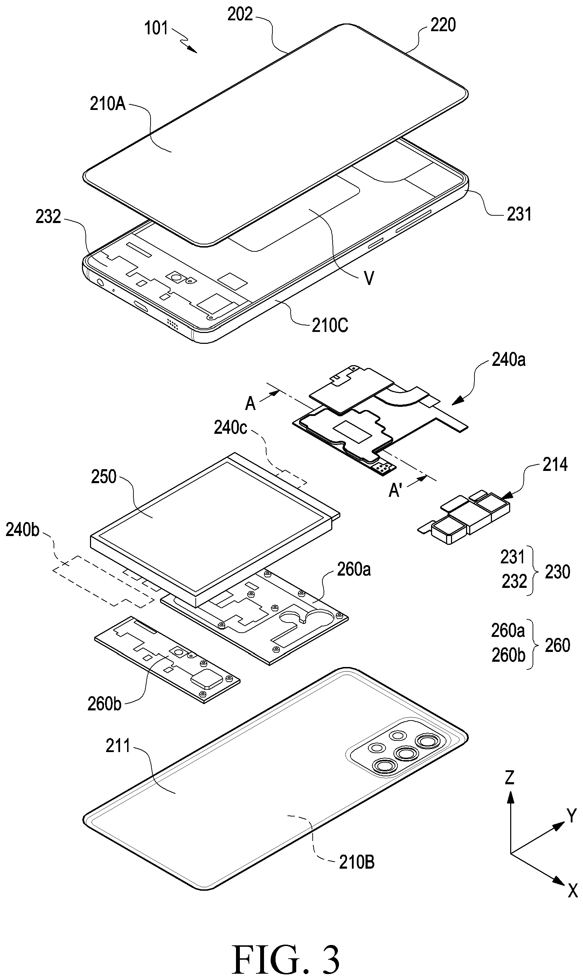

Referring to FIG. 2, according to an embodiment of the disclosure, the electronic device 101 may include a first surface (or a front surface) 210A, a second surface (or a rear surface) (not illustrated), and a third surface (or a side surface) 210C surrounding the space between the first surface 210A and the second surface 210B (see FIG. 3).

According to an embodiment of the disclosure, at least a portion of the first surface 210A may be made of a substantially transparent front surface plate 202 (e.g., a glass plate or a polymer plate including various coating layers). The second surface (or the rear surface) 210B may be made of a substantially opaque rear surface plate (not illustrated). The side surface 210C may be defined by the side surface structure (or a "side surface bezel structure") 218 coupled to the front surface plate 202 and the rear surface plate 211 and including metal and/or polymer.

According to an embodiment of the disclosure, the electronic device 101 may include at least one of a display 220, audio modules 203, 207, and 214, sensor modules 204, key input devices 217, a light-emitting element 206, and connector holes 208 and 209.

According to an embodiment of the disclosure, the display 220 may be visually exposed through a substantial portion of, for example, the front surface plate 202. In an embodiment, at least a portion of the display 220 may be visually exposed through the front surface plate 202 forming the first surface 210A or through a portion of the side surface 210C. In an embodiment, the edge of the display 220 may be formed to be substantially the same as the shape of the periphery of the front surface plate 202 adjacent thereto.

According to an embodiment of the disclosure, the audio modules 203, 207, and 214 may include a microphone hole 203 and speaker holes 207 and 214. A microphone configured to acquire external sound may be placed inside the microphone hole 203, and in an embodiment, one or more microphones may be placed to detect the direction of sound. The speaker holes 207 and 214 may include an external speaker hole 207 and a communication receiver hole 214. In an embodiment, the speaker holes 207 and 214 and the microphone hole 203 may be implemented as a single hole, or a speaker (e.g., a piezo speaker) may be included without the speaker holes 207 and 214.

According to an embodiment of the disclosure, the sensor modules 204 may generate electrical signals or data values corresponding to an internal operating state or an external environmental state of the electronic device 101. The sensor modules 204 may include, for example, a first sensor module 204 (e.g., a proximity sensor) and/or a second sensor module (not illustrated) (e.g., a fingerprint sensor) disposed on the first surface 210A of the housing 210. The fingerprint sensor may be disposed not only on the first surface 210A (e.g., the display 220) of the housing 210, but also on the second surface (not illustrated) or the side surface 210C. The electronic device 101 may further include at least one of, for example, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

According to an embodiment of the disclosure, the camera devices 205 may be disposed on the first surface 210A of the electronic device 101. The camera devices 205 may include one or more lenses, an image sensor, and/or an image signal processor.

According to an embodiment of the disclosure, the key input devices 217 may be disposed on the side surface 210C of the housing 210. In an embodiment, the electronic device 101 may not include some or all of the above-mentioned key input devices 217, and key input devices 217, which are not included, may be implemented in another form, such as soft keys, on the display 220.

According to an embodiment of the disclosure, the light-emitting element 206 may be disposed on, for example, the first surface 210A of the housing 210. The light-emitting element 206 may provide, for example, the state information of the electronic device 101 in an optical form. In an embodiment, the light-emitting element 206 may provide, for example, a light source that is linked with the operation of the camera module 205. The light-emitting element 206 may include, for example, an LED, an IR LED, and a xenon lamp.

The connector holes 208 and 209 may include a first connector hole 208 capable of accommodating a connector (e.g., a USB connector) configured to transmit/receive power and/or data to/from an external electronic device, and a second connector hole (e.g., an earphone jack) 209 capable of accommodating a connector configured to transmit/receive an audio signal to/from an external electronic device.

FIG. 3 is an exploded perspective view of the electronic device 101 according to an embodiment of the disclosure, illustrating the front surface of the electronic device 101.

Referring to FIG. 3, according to an embodiment of the disclosure, an electronic device 101 may include a side surface structure 231, a first support member 232 (e.g., a bracket), a display 220, one or more printed circuit boards (or substrate assemblies) 240a and 240b, a battery 250, a second support member 260, an antenna, a camera assembly 214, and a rear surface plate 211. When including one or more printed circuit boards 240a and 240b, the electronic device 101 may include at least one flexible printed circuit board 240c to electrically connect different printed circuit boards. For example, the printed circuit boards 240a and 240b may include a first substrate assembly 240a disposed on one side (e.g., the upper side or Y direction) of the battery 250 and a second substrate assembly 240b disposed on the other side (e.g., the lower side or -Y direction) of the battery 250, and the first substrate assembly 240a and the second substrate assembly 240b may be electrically connected by a flexible printed circuit board 240c.

According to an embodiment of the disclosure, at least one portion of the first support member 232 may be provided in a flat shape. In an embodiment, the first support member 232 may be disposed inside the electronic device 101 to be connected to the side surface structure 231 or may be integrated with the side surface structure 231. The first support member 232 may be made of, for example, a metal material and/or a non-metal (e.g., polymer) material. When the first support member 232 is at least partially made of a metal material, a portion of the side surface structure 231 or the first support member 232 may serve as an antenna. The first support member 232 may have one surface to which a display 220 is coupled (e.g., in the Z direction) and the substrate assemblies 240a and 240b coupled to the other surface (e.g., in the -Z direction). The substrate assemblies 240a and 240b may include, for example, an interposer, a processor, memory, and/or an interface. The processor may include, for example, one or more of a central processing unit, an application processor, a graphics processing unit, an image signal processor, a sensor hub processor, or a communication processor.

According to an embodiment of the disclosure, the front surface plate 202 may be coupled to the support member 232 via an adhesive member. The front surface plate 202 may be referred to as a "cover" or a "front cover". The rear surface plate 211 may be referred to as a "cover" or a "rear cover". An edge of the cover 211 may be supported by the support member 232.

According to an embodiment of the disclosure, the first support member 232 and the side surface structure 231 may be combined and referred to as a front case or a housing 230. The housing 230 may also be referred to as a frame 230. According to an embodiment, the housing 230 may accommodate the substrate assemblies 240a and 240b and the battery 250.

According to an embodiment of the disclosure, the housing 230 may define at least a portion of the exterior of the electronic device 101. The housing 230 may include a side surface structure 231, a first support member 232, a front surface plate 202, and a rear surface plate 211. In an embodiment of the disclosure, the "front or rear surface of the housing 230" may refer to the front surface plate 202 or the rear cover 211. In an embodiment, the first support member 232 may be disposed between the front surface plate 202 and the rear surface plate 211, and may function as a structure for arranging electrical/electronic components such as the substrate assemblies 240a and 240b or the camera assembly 214.

According to an embodiment of the disclosure, the interface may include, for example, a high-definition multimedia interface (HDMI), a universal serial bus (USB) interface, an SD card interface, and/or an audio interface. The interface may electrically or physically connect, for example, the electronic device 101 to an external electronic device, and may include a USB connector, an SD card/MMC connector, or an audio connector.

According to an embodiment of the disclosure, the second support member 260 may include, for example, an upper support member 260a and a lower support member 260b. In an embodiment, the upper support member 260a may be disposed to surround the substrate assemblies 240a and 240b (e.g., the first substrate assembly 240a) together with a portion of the first support member 232. For example, the upper support member 260a of the second support member 260 may be disposed to face the first support member 232 with the first substrate assembly 240a interposed therebetween.

In an embodiment of the disclosure, the lower support member 260b of the second support member 260 may be disposed to face the first support member 232 with the second substrate assembly 240b interposed therebetween. Circuit devices implemented in the form of integrated circuit chips (e.g., a processor, a communication module, or memory) or various electrical/electronic components may be disposed on a printed circuit boards 240a and 240b. According to an embodiment, the printed circuit boards 240a and 240b may be provided with an electromagnetic shielding environment from the second support member 260. In an embodiment, the lower support member 260b may be used as a structure on which electric/electronic components such as a speaker module and an interface (e.g., a USB connector, an SD card/MMC connector, or an audio connector) may be disposed.

In an embodiment of the disclosure, electrical/electronic components, such as a speaker module and an interface (e.g., a USB connector, an SD card/MMC connector, or an audio connector), may be disposed on an additional printed circuit board (not illustrated). For example, the lower support member 260b may be disposed to surround the additional printed circuit board together with the other portion of the first support member 232.

According to an embodiment of the disclosure, the battery 250 is a device that supplies power to at least one component of the electronic device 101, and may include, for example, a non-rechargeable primary battery, a rechargeable secondary battery, or a fuel cell. At least a portion of the battery 250 may be disposed on substantially the same plane as, for example, the printed circuit boards 240a and 240b. The battery 250 may be integrally disposed inside the electronic device 101 or may be detachably disposed on the electronic device 101.

Although not illustrated, the antenna may include a conductor pattern implemented on the surface of the second support member 260 through, for example, a laser direct structuring method. In an embodiment, the antenna may include a printed circuit pattern provided on the surface of a thin film, and the thin film-type antenna may be disposed between the rear surface plate 211 and the battery 250. The antenna may include, for example, a near-field communication (NFC) antenna, a wireless charging antenna, and/or a magnetic secure transmission (MST) antenna. The antenna may, for example, perform short-distance communication with an external device, or wirelessly transmit and receive power required for charging. In an embodiment, an antenna structure may be configured with a portion or a combination of the side surface structure 231 and/or the first support member 232.

According to an embodiment of the disclosure, the electronic device 101 may include a heat dispersion member V. According to an embodiment, the heat dispersion member V may be disposed on the first support member 232. The heat generated from the inside of the electronic device 101 may be dispersed through the heat dispersion member V or may be dissipated to the outside of the electronic device 101. For example, heat generated from the first substrate assembly 240a may be transferred to the battery 250 through the heat dispersion member. For example, the heat dispersion member may include a vapor chamber or a heat pipe.

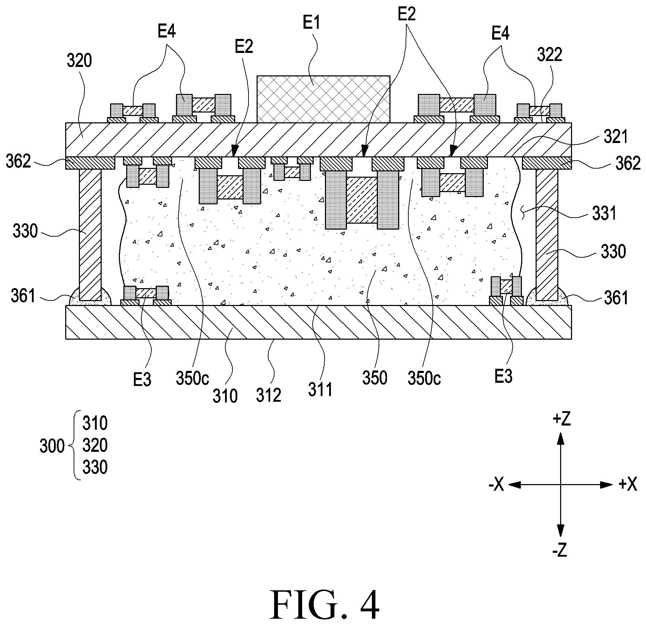

FIG. 4 is a cross-sectional view of a substrate assembly 300 according to an embodiment of the disclosure, taken along cut line A-A' illustrated in FIG. 3. The substrate assembly 300 described with reference to FIGS. 4 to 16 may be included in the substrate assembly 240a described with reference to FIG. 3.

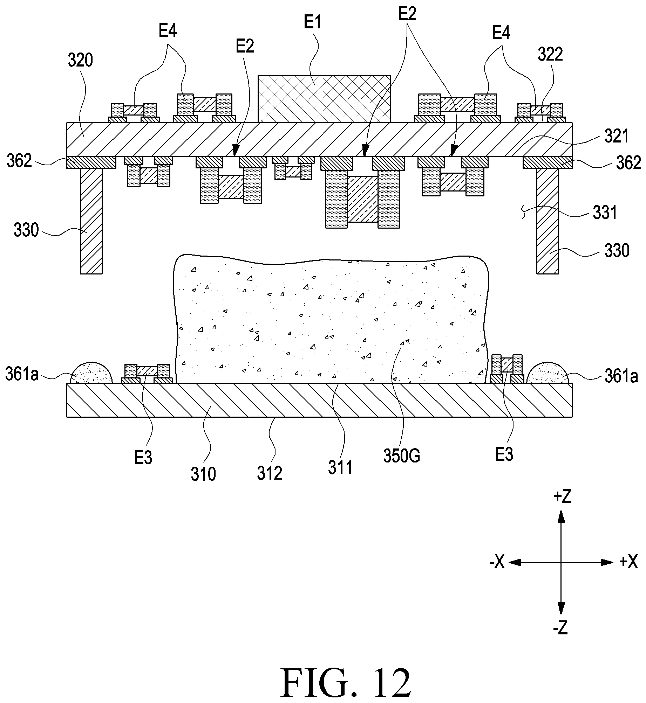

The coordinate axes illustrated in FIG. 4 may correspond to the coordinate axes illustrated in FIGS. 2 and 3. As an example, the +Z-axis direction in FIG. 4 may be the same as the Z-axis direction in FIG. 2 and FIG. 3, and the -Z-axis direction in FIG. 4 may be opposite to the Z-axis direction in FIGS. 2 and 3. Likewise, the +X-axis direction in FIG. 4 may be the same as the X-axis direction in FIGS. 2 and 3, and the -X-axis direction in FIG. 4 may be opposite to the X-axis direction in FIGS. 2 and 3. This may also be applied to FIGS. 12, 13, 15, and 16 described below.

Referring to FIG. 4, according to an embodiment of the disclosure, the substrate assembly 300 may include a first substrate 310. The first substrate 310 may include a first surface 311 and a second surface 312 opposite to the first surface 311. As an example, the first substrate 310 may be a printed circuit board having one or more electrical components (e.g., the third electronic components E3) disposed on the first surface 311 and the second surface 312.

According to an embodiment of the disclosure, the substrate assembly 300 may include a second substrate 320. The second substrate 320 may include a third surface 321 facing the first surface 311 of the first substrate 310. The second substrate 320 may include a fourth surface 322 opposite to the third surface 321. As an example, the second substrate 320 may be a printed circuit board having one or more electrical components (e.g., the second electronic components E2 or the fourth electronic components E4) disposed on the third surface 321 and the fourth surface 322.

According to an embodiment of the disclosure, the substrate assembly 300 may include an interposer 330 disposed between the first surface 311 of the first substrate 310 and the third surface 321 of the second substrate 320. The first substrate 310 and the second substrate 320 may be electrically connected via the interposer 330. The interposer 330 may be electrically connected to the first substrate 310 via a first solder 361. The interposer 330 may be electrically connected to the second substrate 320 via a second solder 362. As an example, the interposer 330 may be electrically connected to the first substrate 310 and the second substrate 320 through a via disposed at an edge of the first substrate 310 and/or the second substrate 320.

According to an embodiment of the disclosure, the interposer 330 may surround the heat dissipation member 350. As an example, the interposer 330 may extend annularly along the edge of the first substrate 310 and/or the second substrate 320. According to another embodiment of the disclosure (not illustrated), the interposer 330 may partially surround the heat dissipation member 350. As an example, the interposer 330 may entirely surround the heat dissipation member 350 together with another structure (e.g., a structure protruding from the first surface 311 of the first substrate 310).

According to an embodiment of the disclosure, the substrate assembly 300 may include an internal space 331 that is at least partially surrounded by, or at least partially defined by, the first surface 311 of the first substrate 310, the third surface 321 of the second substrate 320, and the interposer 330. The internal space 331 may be referred to as an internal space 331 of the substrate assembly 300.

According to an embodiment of the disclosure, the electronic device 101 may include an electronic component E1 disposed on the fourth surface 322 of the second substrate 320. As an example, the electronic component E1 may include an application processor (e.g., the processor 130 in FIG. 1) that includes multiple processing cores. The heat generated during the operation of the electronic component E1 may be transferred from the electronic component E1 to a surrounding structure (e.g., the second substrate 320 and/or the heat dissipation member 350).

According to an embodiment of the disclosure, the electronic device 101 may include second electronic components E2 disposed on the third surface 321 of the second substrate 320. The second electronic components E2 may be in contact with the heat dissipation member 350. The heat dissipation member 350 may cover the second electronic components E2. The heat dissipation member 350 may partially surround the second electronic components E2.

According to an embodiment of the disclosure, the second electronic component E2 may include a component that performs a function independent of the first electronic component E1, or a component that is operatively connected to the first electronic component E1. As an example, the second electronic components E2 may include one or more decoupling capacitor that is electrically connected to the first electronic component E1 via the second substrate 320 and configured to stabilize power supplied to the first electronic component E1.

According to an embodiment of the disclosure, the electronic device 101 may include third electronic components E3 disposed on the first surface 311 of the first substrate 310. The third electronic components E3 may be positioned at an edge of the heat dissipation member 350. The third electronic components E3 may be at least partially covered by the heat dissipation member 350.

According to an embodiment of the disclosure, the electronic device 101 may include fourth electronic components E4 disposed on the fourth surface 322 of the second substrate 320. The fourth electronic components E4 may be positioned around the first electronic component E1. For example, the fourth electronic components E4 may include an electrical element (e.g., a capacitor) or an integrated circuit.

According to an embodiment of the disclosure, the electronic device 101 may include the heat dissipation member 350 disposed in the internal space 331. The heat dissipation member 350 may be disposed in the internal space 331. The heat dissipation member 350 may be in contact with the third surface 321 of the second substrate 320. The heat generated from the first electronic component E1 may be dissipated to the outside of the first electronic component E1 via the heat dissipation member 350 that is in contact with the third surface 321.

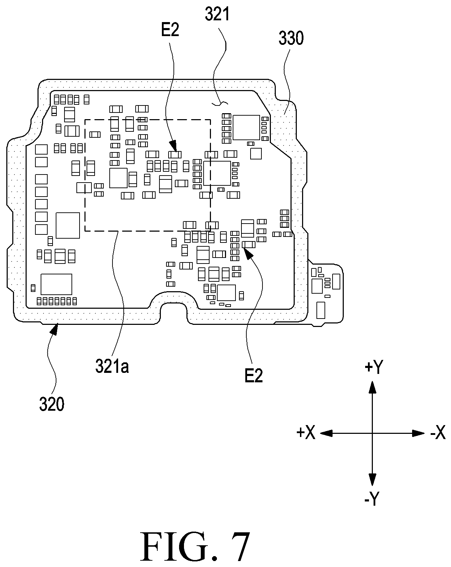

According to an embodiment of the disclosure, the heat dissipation member 350 may include a contacting portion 350c that is positioned, for example, between a plurality of second electronic components E2 and is in contact with the third surface 321. The heat dissipation member 350 may include one or more contacting portions 350c. The contacting portions 350c may be in contact with at least one of the second electronic components E2 and/or the third surface 321. As an example, the contacting portion 350c may be positioned between the plurality of decoupling capacitors and may be in contact with an area of the third surface 321 that overlaps with the first electronic component E1 (e.g., the area 321a in FIG. 7).

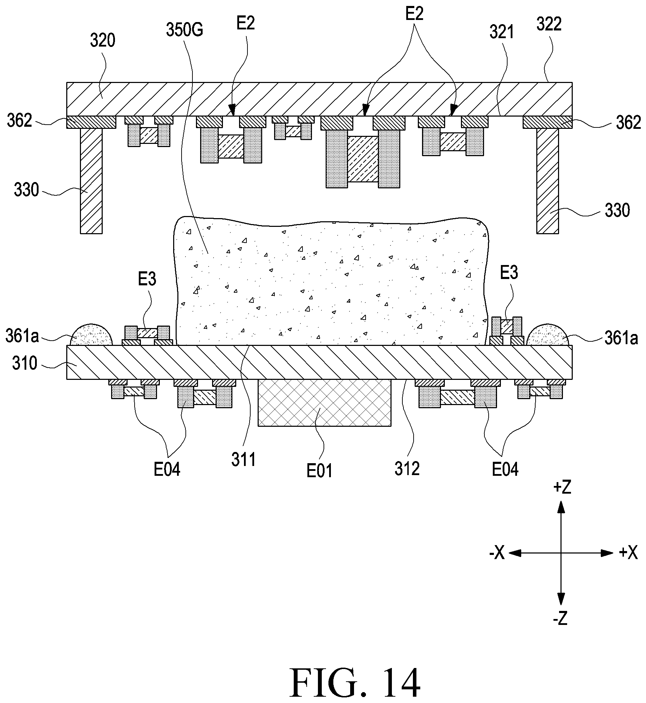

According to an embodiment of the disclosure, the heat dissipation member 350 may be supported by the first surface 311 of the first substrate 310. As an example, the heat dissipation member 350 may be bonded to the first surface 311. The heat dissipation member 350 may be bonded to the first surface 311 by an adhesive member 370 (see FIG. 14) disposed between the first surface 311 and the heat dissipation member 350. The heat dissipation member 350 may be fixed to the first substrate 310 by the adhesive member 370. The adhesive member 370 will be described in detail later with reference to FIG. 14. As another example, the heat dissipation member 350 may be in direct contact with the first surface 311.

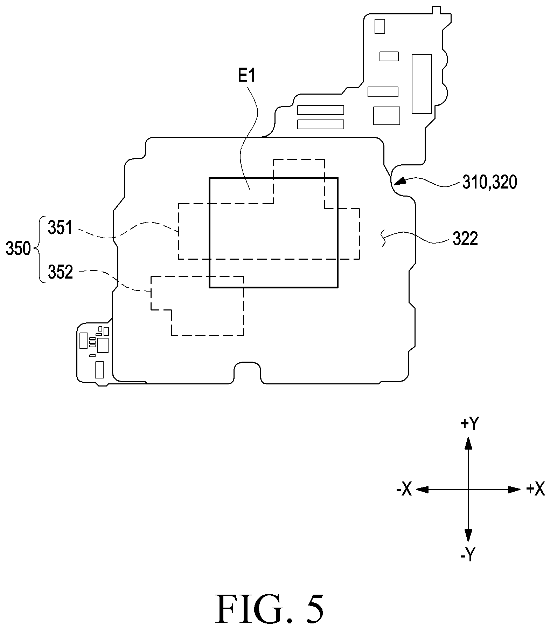

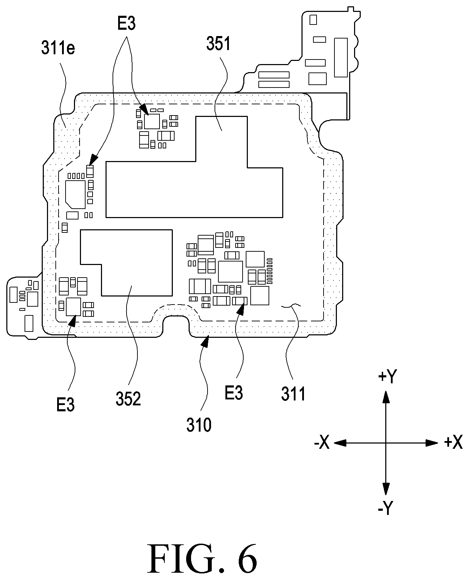

FIG. 5 is a perspective view of the substrate assembly 300 according to an embodiment of the disclosure. FIG. 6 illustrates the first substrate 310 included in the substrate assembly 300 illustrated in FIG. 5 and components disposed on the first substrate 310. FIG. 7 illustrates the second substrate 320 included in the substrate assembly 300 illustrated in FIG. 5 and components disposed on the second substrate 320.

The coordinate axes illustrated in FIG. 5 may correspond to the coordinate axes illustrated in FIGS. 2 and 3. As an example, the +Y-axis direction in FIG. 5 may be the same as the Y-axis direction in FIGS. 2 and 3, and the -Y-axis direction in FIG. 5 may be opposite to the Y-axis direction in FIGS. 2 and 3. Likewise, the +X-axis direction in FIG. 5 may be the same as the X-axis direction in FIG. 2 and FIG. 3, and the -X-axis direction in FIG. 5 may be opposite to the X-axis direction in FIGS. 2 and 3. This may be equally applied to FIGS. 6 and 7.

Referring to FIGS. 5 to 7, according to an embodiment of the disclosure, the heat dissipation member 350 may be disposed in the internal space 331 to overlap with the first electronic component E1 when viewed from above the fourth surface 322 (e.g., when viewed in a direction perpendicular to the fourth surface 322). The heat generated from the first electronic component E1 may be effectively dissipated via an area of the heat dissipation member 350 that overlaps with the first electronic component E1.

According to an embodiment of the disclosure, the electronic device 101 may include a plurality of heat dissipation members 351 and 352. The plurality of heat dissipation members 351 and 352 may include a first heat dissipation member 351 and a second heat dissipation member 352. The first heat dissipation member 351 and the second heat dissipation member 352 may have different shapes.

According to an embodiment of the disclosure, the second electronic components E2 may be positioned at an area 321a that overlaps with the first electronic component E1 when viewed in a direction perpendicular to the third surface 321. The second electronic components E2 may be positioned between the heat dissipation member 350 and the first electronic component E1. In addition, the second electronic components E2 may be positioned at an area that does not overlap with the first electronic component E1 when viewed in a direction perpendicular to the third surface 321.

According to an embodiment of the disclosure, a plurality of vias may be positioned at an edge 311e of the first surface 311. The interposer 330 may include a plurality of vias. The first substrate 310 and the second substrate 320 may be electrically connected via the plurality of vias of the interposer 330.

According to an embodiment of the disclosure, the interposer 330 may be elongated along the edge 311e of the first surface 311 of the first substrate 310. The interposer 330 may at least partially surround the heat dissipation member 350. The heat dissipation member 350 may be spaced apart from the edge 311e of the first surface 311 of the first substrate 310. When the heat dissipation member 350 is viewed from above the first surface 311 (when viewed in a direction perpendicular to the first substrate 310), the heat dissipation member 350 may be positioned on the inner side of the edge 311e of the first substrate 310.

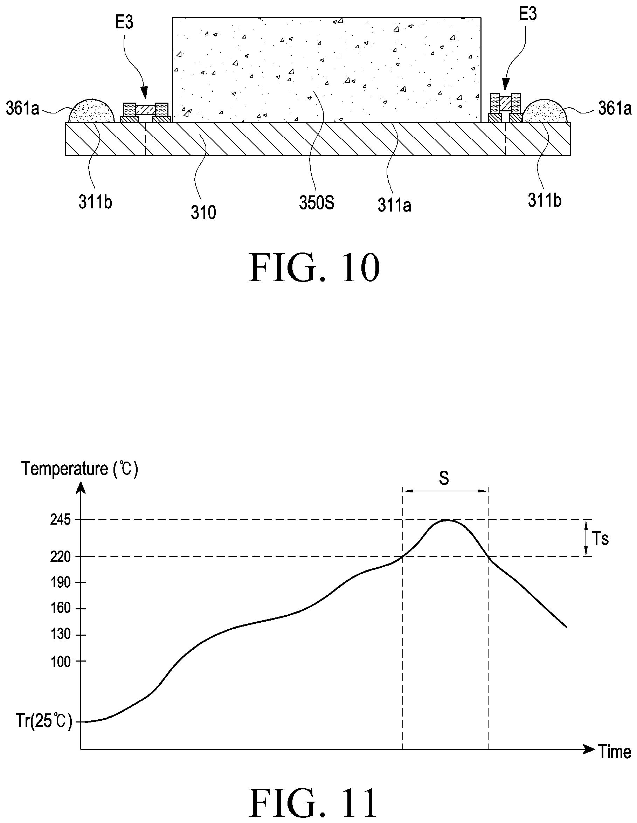

According to an embodiment of the disclosure, during the manufacturing process of the substrate assembly 300 (see FIG. 4), solder paste 361a (see FIG. 10) may be applied to the edge 311e of the first surface 311 of the first substrate 310. The heat dissipation member 350 is spaced apart from the edge 311e of the first surface 311 on which the solder paste 361a is applied, thereby preventing a bonding defect that may occur during the process in which the interposer 330 and the first substrate 310 are connected through soldering.

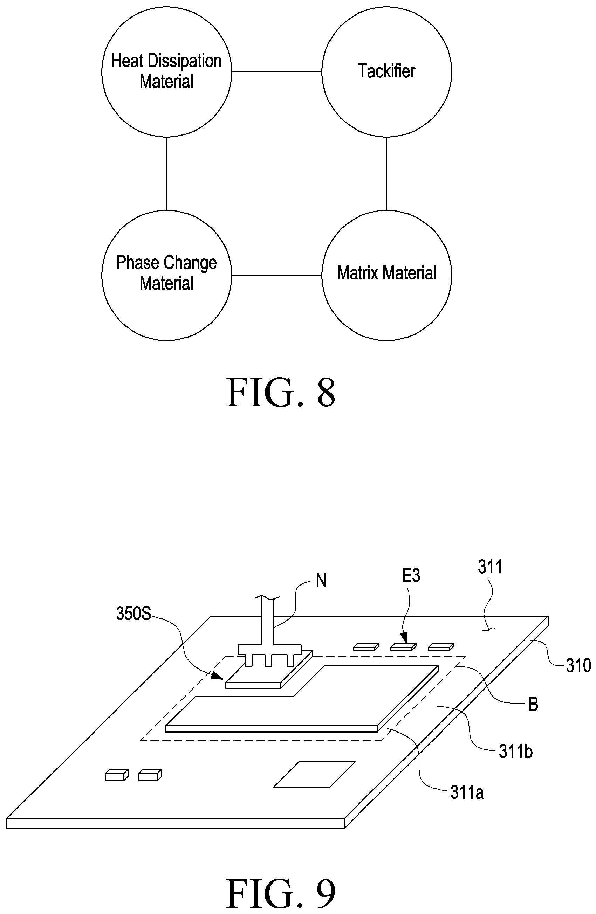

FIG. 8 is a view illustrating the composition of the heat dissipation member 350 according to an embodiment of the disclosure, and illustrates materials that may be included in the heat dissipation member 350.

Referring to FIG. 8, the heat dissipation member 350 may include a heat dissipation particles. The heat dissipation particles may have insulating properties and/or high thermal conductivity. As an example, the heat dissipation particles may include a ceramic-based material such as alumina (Al₂O₃) or aluminum nitride (AlN), carbon fiber, graphene, boron nitride (BN), silicon carbide (SiC), magnesium oxide (MgO), zinc oxide (ZnO), or a combination thereof.

According to an embodiment of the disclosure, the heat dissipation member 350 may exhibit thermoresponsive behavior, allowing its physical properties, such as phase or thermal conductivity, to change in response to its temperature. For instance, at room temperature, the heat dissipation member 350 may remain in a solid phase, but when it absorbs ambient heat and is heated, it transitions into a gel phase (or rubbery state). This thermoresponsive behavior enhances the heat dissipation efficiency of the heat dissipation member 350. The heat dissipation member 350 may comprise a heat dissipation material, phase change material (PCM), and a matrix material. Further details regarding the materials included in the heat dissipation member 350 are provided below.

According to an embodiment of the disclosure, the heat dissipation member 350 may include a phase change material. The phase change material may include a heat-responsive material or a thermoplastic polymer. As an example, the phase change material may include an organic material having a glass transition temperature or a melting point ranging from 40 degrees Celsius to 60 degrees Celsius, such as a paraffin-based material, polyethylene glycol, and/or a salt hydrate, or a combination thereof.

According to an embodiment of the disclosure, the heat dissipation member 350 may include a matrix material configured to maintain the heat dissipation member 350 in the gel phase. The matrix material may include a thermoplastic organic material. For example, the matrix material may include a rubber-based material having elasticity, and more specifically, may include ethylene vinyl acetate (EVA) and/or styrene ethylene butylene styrene (SEBS).

According to an embodiment of the disclosure, the heat dissipation member 350 including the phase change material, and the matrix material may be in a solid phase at room temperature (e.g., 25 degrees Celsius). The heat dissipation member 350 may be softened as the temperature increases. The temperature at which the heat dissipation member 350 begins to soften may be referred to as a softening temperature or a softening point.

According to an embodiment of the disclosure, when the heat dissipation member 350 is in the solid phase, the transport and placement of the heat dissipation member 350 may be easier compared to when it is in the liquid or gel phase. In addition, the heat dissipation member 350, which has a certain level of rigidity in the solid state, may reduce defects such as dents or indentations of the heat dissipation member 350 that may occur during assembly and transportation. Accordingly, the shape of the heat dissipation member 350 may be prevented from being deformed, and the dispersion of the heat dissipation performance of the heat dissipation member 350 may be minimized.

According to an embodiment of the disclosure, when the temperature of the heat dissipation member 350 increases, the heat dissipation member 350 may at least partially change into the gel phase. For example, when the electronic component E1 operates and generates heat, the heat dissipation member 350 that has absorbed the heat generated from the electronic component E1 may transition to the gel phase, which is softer compared to its solid phase at room temperature. The heat dissipation member 350 may be in the gel phase within a temperature range equal to or higher than a softening point higher than the room temperature.

According to an embodiment of the disclosure, the matrix material may maintain the heat dissipation member 350 in the gel phase at a temperature higher than the melting point (or glass transition temperature) of the phase change material. When the temperature of the heat dissipation member 350 reaches the softening point, the flowability of the phase change material increases, but the shape of the heat dissipation member 350 may be substantially maintained by the matrix material.

According to an embodiment of the disclosure, the heat dissipation member 350 may include about 75 to 90 wt%(weight percentage) of the heat dissipation particles, about 5 to 15 wt% of the matrix material, and/or about 5 to 15 wt% of the phase change material. The composition ratio of the heat dissipation particles, the matrix material, and/or the phase change material included in the heat dissipation member 350 is not limited to the above examples.

According to an embodiment of the disclosure, the heat dissipation member 350 may include a tackifier configured to provide tack. The tackifier may provide tack to the phase change material. The tackifier may suppress the flowability of the phase change material that increases as the temperature increases. The tackifier may comprise at least one functional group different from a functional group of the matrix material. As an example, the tackifier may include a hydrogenated hydrocarbon.

According to an embodiment of the disclosure, the tackifier may have a glass transition temperature higher than the melting point (or glass transition temperature) of the phase change material. Therefore, the heat dissipation member 350 including the phase change material and the tackifier may have a glass transition temperature (or softening temperature) higher than the melting point (or glass transition temperature) of the phase change material.

According to an embodiment of the disclosure, the heat dissipation member 350 may include about 80 wt% to 86 wt% of the heat dissipation particles, about 1 wt% to 3 wt% of the phase change material, about 1 wt% to 3 wt% of the tackifier, and about 8 wt% to 12.5 wt% of the matrix material. The composition ratio of the heat dissipation particles, the matrix material, the phase change material, and the tackifier included in the heat dissipation member 350 is not limited to the above examples.

According to an embodiment of the disclosure, the weight ratio (wt%) of the phase change material and the tackifier included in the heat dissipation member 350 may be about 1:1. The phase change material may increase the heat dissipation performance of the heat dissipation member 350 through phase change. The tackifier may suppress the flowability of the phase change material by imparting tack to the phase change material. Therefore, by forming the phase change material and the tackifier at a weight ratio of about 1:1, high heat dissipation performance of the heat dissipation member 350 may be secured, and excessive shape deformation may be prevented.

FIG. 9 illustrates a state in which the heat dissipation member 350 is disposed on a substrate (e.g., the first substrate 310) according to an embodiment of the disclosure. FIG. 10 is a cross-sectional view of a substrate (e.g., the first substrate 310) on which the heat dissipation member 350 is disposed according to the process illustrated in FIG. 9. Hereinafter, for convenience of description, when the heat dissipation member 350 is in the solid phase, the reference numeral 350S is indicated, and when the heat dissipation member 350 is in the gel phase, the reference numeral 350G is indicated.

Referring to FIGS. 9 and 10, according to an embodiment of the disclosure, the heat dissipation member 350S, which is in the solid phase at room temperature, may be disposed on the first surface 311 of the first substrate 310 through surface mount technology (SMT). The heat dissipation member 350S may be adsorbed to a nozzle N and disposed at a predetermined position (e.g., the first portion 311a) of the first surface 311. Therefore, the solid heat dissipation member 350S may be easily positioned at a position where heat dissipation is facilitated for a high heat-generating component (e.g., an application processor), such as a position overlapping with or adjacent to the high heat-generating component. Accordingly, the high heat-generating component may be effectively heat dissipated.

According to an embodiment of the disclosure, the first substrate 310 may include a first portion 311a and a second portion 311b. The first portion 311a and the second portion 311b may be divided based on a predetermined boundary B. The heat dissipation member 350S may be placed at the first portion 311a. A solder paste 361a for bonding the interposer 330 (see FIG. 4) to the first substrate 310 may be disposed at the second portion 311b. The solder paste 361a may correspond to the first solder 361 (see FIG. 4) of the substrate assembly 300. As an example, the conductive material may include a SAC (silver, aluminum, copper) solder paste having a melting point ranging from 217 degrees Celsius to 221 degrees Celsius.

FIG. 11 is a graph showing a temperature profile in a reflow soldering process according to an embodiment of the disclosure. FIG. 12 is a cross-sectional view illustrating a heat dissipation member 350G which is in the gel phase in the soldering section S shown in FIG. 11.

Referring to FIGS. 11 and 12, the substrate assembly 300 (see FIG. 4) according to an embodiment of the disclosure may be manufactured through a reflow soldering process. The reflow soldering process may include a soldering section S. The temperature in the soldering section S may be referred to as a soldering temperature Ts or a soldering temperature range Ts. As an example, the soldering temperature Ts may range from 220 degrees Celsius to 245 degrees Celsius.

According to an embodiment of the disclosure, in the soldering section S, the solder paste 361a may be in a liquid state. In the soldering section S, the heat dissipation member 350G may maintain the gel phase. The soldering temperature Ts may be higher than the softening temperature of the heat dissipation member 350. By the matrix material included in the heat dissipation member 350, the shape of the gel-phase heat dissipation member 350G may be substantially maintained in the soldering section S. By the tackifier included in the heat dissipation member 350, the shape of the gel-phase heat dissipation member 350G may be substantially maintained in the soldering section S.

According to an embodiment of the disclosure, the amount of vaporization of the phase change material in the soldering section S may be reduced by the tackifier. Even if the fluidity of the phase change material included in the heat dissipation member 350 increases due to the high temperature in the soldering section S, the phase change material may adhere to the tackifier by the adhesion of the tackifier. Therefore, by reducing the amount of loss of the phase change material, the heat dissipation performance of the heat dissipation member 350 may be prevented from being deteriorated. In addition, the damage (e.g., mass loss) of the heat dissipation member 350 that may occur during the process of placing the heat dissipation member 350 in the internal space 331 of the substrate assembly 300 (see FIG. 4) may be minimized.

According to an embodiment of the disclosure, the shape of the gel-phase heat dissipation member 350G may be substantially maintained in the soldering section S by the matrix material and/or the tackifier. Accordingly, the gel-phase heat dissipation member 350G may be prevented from flowing down to the area where the solder paste 361a is applied, which may cause a bonding failure of the interposer 330.

Referring to FIG. 4 and FIGS. 10 to 12, the substrate assembly 300 may be assembled in the soldering section S. According to an embodiment of the disclosure, the substrate assembly 300 may be manufactured according to the operation of placing a heat dissipation member 350 as described with reference to FIGS. 9 and 10 (hereinafter, referred to as "first operation"), the operation of softening the heat dissipation member 350 as described with reference to FIGS. 11 and 12 (hereinafter, referred to as "second operation"), the operation of assembling a substrate assembly 300 like the substrate assembly 300 illustrated in FIG. 4 (hereinafter, referred to as "third operation"), and the operation of cooling the substrate assembly 300 (hereinafter, referred to as "fourth operation").

The second to fourth operations will be described in detail with reference to FIGS. 4 and 12. In the soldering section S, the solder paste 361a applied to an edge (e.g., the edge 311e in FIG. 6) of the first surface 311 of the first substrate 310 may be in the liquid phase, and the heat dissipation member 350 disposed on the first surface 311 may be in the gel phase. Thereafter, when the interposer 330 and the second substrate 320, which have been bonded in advance, may be pressed to come close to the first substrate 310, the soft gel-phase heat dissipation member 350G may be pressed. Then, the pressed gel-phase heat dissipation member 350G may be introduced the space between the components (e.g., the second electronic components E2) disposed on the third surface 321 of the second substrate 320 and may come into contact with the third surface 321. Thereafter, when the substrate assembly 300 is sufficiently cooled, the gel-phase heat dissipation member 350S disposed in the internal space 331 may transition into the solid phase.

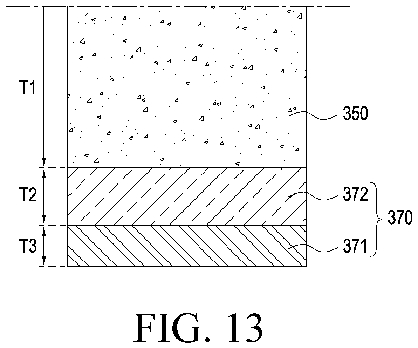

FIG. 13 is a cross-sectional view of a heat dissipation member 350 and an adhesive member 370 according to an embodiment of the disclosure.

Referring to FIG. 13, the heat dissipation member 350 according to an embodiment of the disclosure may be bonded to the first substrate 310 (see FIG. 4) by the adhesive member 370. The adhesive member 370 may be disposed between the heat dissipation member 350 and the first substrate 310. Accordingly, since the heat dissipation member 350 is stably fixed on the first substrate 310, problems such as warping or lifting may be reduced.

According to an embodiment of the disclosure, the adhesive member 370 may include a first adhesive layer 371 that is bonded to the first surface 311 of the first substrate 310. As an example, the first adhesive layer 371 may include an acrylic adhesive.

According to an embodiment of the disclosure, the adhesive member 370 may include a second adhesive layer 372 disposed between the heat dissipation member 350 and the first adhesive layer 371. The second adhesive layer 372 may include an adhesive different from the first adhesive layer 371. The second adhesive layer 372 may include a hot melt adhesive.

According to an embodiment of the disclosure, the second adhesive layer 372 including the hot melt adhesive may be in the solid state at room temperature (e.g., 25 degrees Celsius). Since the second adhesive layer 372 in the solid state provides rigidity to the heat dissipation member 350, the heat dissipation member 350 may be placed by surface mount technology (SMT) described with reference to FIG. 9.

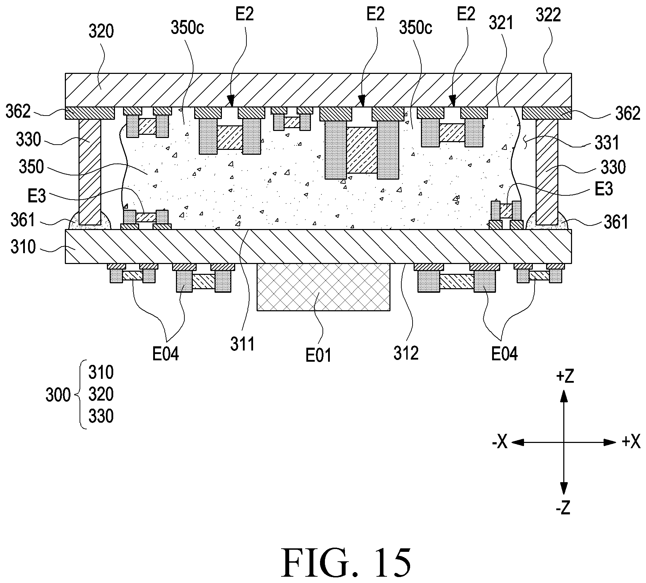

FIG. 14 is a cross-sectional view illustrating the heat dissipation member 350 softened in a reflow soldering process according to another embodiment of the disclosure. FIG. 15 illustrates the state in which the substrate assembly 300 is assembled in the soldering section S (see FIG. 10) of reflow soldering according to another embodiment of the disclosure. The description of the reflow soldering process described with reference to FIG. 10 may be equally applied to the reflow soldering process to be described with reference to FIG. 14 and FIG. 15.

The description of the components provided with reference to FIG. 4 (e.g., the first electronic component E1, and/or the fourth electronic components E4) may be applied in a substantially similar manner to the components with the same names in FIGS. 14 and 15 (e.g., the first electronic component E01, and/or the fourth electronic components E04), to the extent that they do not contract each other.

The description of the second operation, the third operation, and the fourth operation described with reference to FIG. 4 and FIGS. 10 to 12 may be applied in a substantially similar manner to the following description with reference to FIG. 14 and FIG. 15 to the extent that they do not contradict each other. The description of the second operation may be applied in a substantially similar manner to the description with reference to FIG. 14. The description of the third operation and the fourth operation may be applied in a substantially similar manner to the description with reference to FIG. 15.

Referring to FIGS. 14 and 15, according to another embodiment of the disclosure, the first electronic component E01 and the fourth electronic components E04 may be disposed on the second surface 312 of the first substrate 310. The heat dissipation member 350 may be in contact with the first surface 311 of the first substrate 310. The heat dissipation member 350 may be disposed in the internal space 331 to overlap with the first electronic component E01 when viewed in a direction perpendicular to the second surface 322. The heat dissipation member 350 may provide a heat transfer path through which heat generated from the first electronic component E01 is dissipated.

As the integration of electronic components (e.g., application processors) increases and their performance improves, the amount of heat generated by these components continues to increase. Heat generation in electronic components may affect the performance of electronic devices (e.g., performance degradation caused by throttling). Thus, extensive research is being conducted on the heat dissipation structures of electronic components.

A problem the disclosure seeks to solve may be to provide a heat dissipation structure for effectively dissipating heat from electronic components (e.g., application processors).

A problem that the disclosure seeks to solve may be to provide a method for easily placing a heat dissipation member at a specific position inside a substrate assembly.

A problem that the disclosure seeks to solve may be to minimize mass loss of a heat dissipation member including a phase change material.

The problems that the disclosure seeks to solve are not limited to the aforementioned problems, and may be expanded in various ways without departing from the spirit and scope of the disclosure.

In an electronic device according to various embodiments of the disclosure, a solid-phase heat dissipation member of an electronic component may be placed at a position where heat dissipation for the electronic component is facilitated, thereby effectively dissipating heat from the electronic component.

In an electronic device according to various embodiments of the disclosure, a solid heat dissipation member may be placed on a substrate and then a substrate assembly is assembled, thereby providing a method for easily placing a heat dissipation member inside a substrate assembly.

In an electronic device according to various embodiments of the disclosure, a tackifier that provides adhesion to a heat dissipation member may be included, thereby minimizing loss of a phase change material included in the heat dissipation member.

The effects that are capable of being obtained by the disclosure are not limited to those described above, and other effects not described above may be clearly understood by a person ordinarily skilled in the art to which the disclosure belongs based on the following description.

According to an embodiment of the disclosure, an electronic device 101 may include a first substrate 310 including a first surface 311 and a second surface 312 opposite to the first surface 311.

According to an embodiment of the disclosure, the electronic device 101 may include a second substrate 320 including a third surface 321 facing the first surface 311 and a fourth surface 322 opposite to the third surface 321.

According to an embodiment of the disclosure, the electronic device 101 may include an interposer 330 disposed between the first surface 311 and the third surface 321.

According to an embodiment of the disclosure, the electronic device 101 may include a first electronic component E1 disposed on the fourth surface 322.

According to an embodiment of the disclosure, the electronic device 101 may include a heat dissipation member 350 which is in a gel phase.

According to an embodiment of the disclosure, the heat dissipation member 350 may be disposed in a space 331 defined by the first substrate 310, the second substrate 320, and the interposer 330 so as to overlap with the first electronic component E when viewed in a direction perpendicular to the fourth surface 322.

According to an embodiment of the disclosure, the heat dissipation member 350 may be in a gel phase within a temperature range equal to or higher than a softening point higher than the room temperature.

According to an embodiment of the disclosure, the electronic device may further include a solder 361 or 362 electrically connecting the interposer 330 with the first substrate 310 or the second substrate 320.

According to an embodiment of the disclosure, the heat dissipation member 350 may be configured to maintain the gel phase at the melting point of the solder 350 which is higher than the softening point.

According to an embodiment of the disclosure, the electronic device may further include at least one second electronic component E2 disposed on the third surface 321 of the second substrate 320.

According to an embodiment of the disclosure, the heat dissipation member 350 may include a contacting portion 350c which is in contact with the at least one second electronic component E2 or the third surface 321.

According to an embodiment of the disclosure, the second electronic component E2 may be positioned between the heat dissipation member 350 and the first electronic component E1.

According to an embodiment of the disclosure, the second electronic component E2 may include a plurality of decoupling capacitors electrically connected to the first electronic component E1 via the second substrate 320.

According to an embodiment of the disclosure, the contacting portion 350c of the heat dissipation member 350 may be located between the plurality of decoupling capacitors and may be in contact with the third surface 321.

According to an embodiment of the disclosure, the electronic device may further include third electronic components E3 disposed on the first surface 311 of the first substrate 310 and at least partially covered by the heat dissipation member 350.

According to an embodiment of the disclosure, the heat dissipation member 350 may include a phase change material having a melting point ranging from 40 degrees Celsius to 60 degrees Celsius.

According to an embodiment of the disclosure, the heat dissipation member 350 may include a matrix material configured to maintain the heat dissipation member in the gel phase at a temperature higher than the melting point of the phase change material.

According to an embodiment of the disclosure, the heat dissipation member 350 may further include a tackifier configured to provide tack to the phase change material.

According to an embodiment of the disclosure, the matrix material may include a thermoplastic organic material.

According to an embodiment of the disclosure, the tackifier may include a petroleum hydrocarbon resin.

According to an embodiment of the disclosure, the tackifier may comprise at least one functional group different from a functional group of the matrix material.

According to an embodiment of the disclosure, the tackifier may have a glass transition temperature which is higher than the melting point of the phase change material.

According to an embodiment of the disclosure, the weight ratio of the phase change material and the tackifier may be 1:1.

According to an embodiment of the disclosure, the electronic device may further include an adhesive member 370 disposed between the first surface 311 of the first substrate 310 and the heat dissipation member 350.

According to an embodiment of the disclosure, the adhesive member 370 may include a first adhesive layer 371 bonded to the first surface 311 of the first substrate 310.

According to an embodiment of the disclosure, the adhesive member 370 may include a second adhesive layer 372 disposed between the first adhesive layer 371 and the heat dissipation member 350 and including a hot melt adhesive.

According to an embodiment of the disclosure, the heat dissipation member 350 may be in contact with the first surface 311 of the first substrate 310 by the adhesive member 370 and may be in contact with the third surface 321 of the second substrate 320.

According to an embodiment of the disclosure, the heat dissipation member 350 may be in contact with an area 321a of the third surface 321, which overlaps with the first electronic component E1 when viewed in the direction perpendicular to the fourth surface 322.

According to an embodiment of the disclosure, the interposer 350 is elongated along an edge 311e of the first surface 311 of the first substrate 310 so as to at least partially surround the heat dissipation member 350 and electrically connects the first substrate 310 and the second substrate 320.

According to an embodiment of the disclosure, the electronic device 101 may include an electronic component E01 disposed on the second surface 312.

According to an embodiment of the disclosure, the heat dissipation member 350 may be disposed in a space 331 defined by the first substrate 310, the second substrate 320, and the interposer 330 so as to overlap with the first electronic component E01 when viewed in a direction perpendicular to the second surface 322.

Although specific embodiments have been described above in the detailed description of the disclosure, it will be apparent to those skilled in the art that various modifications and changes may be made thereto without departing from the scope of the disclosure.

## Claims

1. An electronic device comprising:
a first substrate (310) comprising a first surface (311) and a second surface (312) opposite to the first surface;
a second substrate (320) comprising a third surface (321) facing the first surface and a fourth surface (322) opposite to the third surface;
at least one interposer (330) disposed between the first surface and the third surface and electrically connecting the first substrate and the second substrate;
a first electronic component (E1) disposed on the fourth surface; and
a heat dissipation member (350) being in a solid phase at room temperature (Tr) and disposed in a space (331) defined by the first substrate, the second substrate, and the at least one interposer so as to overlap with the first electronic component when viewed in a direction orthogonal to the fourth surface.

2. The electronic device of claim 1, wherein the heat dissipation member (350) is in a gel phase within a temperature range above a softening point higher than room temperature.

3. The electronic device of claim 2, further comprising a solder (361, 362) electrically connecting the at least one interposer(330) with the first substrate (310) or the second substrate(320),
wherein the heat dissipation member (350) is configured to maintain being in the gel phase at a melting point of the solder (350) which is higher than the softening point.

4. The electronic device of any one of claims 1 to 3, further comprising at least one second electronic component (E2) disposed on the third surface (321) of the second substrate (320),
wherein the heat dissipation member (350) comprises a contacting portion (350c) which contacts at least one of the third surface or the at least one second electronic component (E2).

5. The electronic device of claim 4,
wherein the at least one second electronic component (E2) comprises a plurality of decoupling capacitors positioned between the heat dissipation member (350) and the first electronic component (E1) and electrically connected to the first electronic component (E1) via the second substrate(320),
wherein the contacting portion(350c) of the heat dissipation member(350) is positioned between the plurality of decoupling capacitors and contacts the third surface (321).

6. The electronic device of claim 4 or 5, further comprising a third electronic component (E3) disposed on the first surface (311) of the first substrate (310) and at least partially covered by the heat dissipation member (350).

7. The electronic device of any one of claims 1 to 6,
wherein the heat dissipation member (350) comprises:
a phase change material having a melting point ranging from 40 degrees Celsius to 60 degrees Celsius; and
a matrix material configured to maintain the heat dissipation member in a gel phase at a temperature higher than the melting point of the phase change material.

8. The electronic device of claim 7,
wherein the heat dissipation member (350) further comprises a tackifier configured to provide tack to the phase change material.

9. The electronic device of claim 8, wherein:
the matrix material comprises a thermoplastic organic material, and
the tackifier comprises a petroleum hydrocarbon resin.

10. The electronic device of claim 9,
wherein the tackifier comprises at least one functional group different from a functional group of the matrix material.

11. The electronic device of any one of claims 8 to 10,
wherein the tackifier has a glass transition temperature higher than the melting point of the phase change material.

12. The electronic device of claim 11,
wherein a weight ratio of the phase change material and the tackifier is 1:1.

13. The electronic device of any one of claims 1 to 12, further comprising an adhesive member (370) disposed between the first surface(311) of the first substrate (310) and the heat dissipation member(350).

14. The electronic device of claim 13, wherein the adhesive member(370) comprises:
a first adhesive layer (371) disposed on the first surface (311)of the first substrate(310); and
a second adhesive layer (372) disposed between the first adhesive layer(371) and the heat dissipation member (350) and comprising a hot melt adhesive(350),
wherein the heat dissipation member (350) is in contact with the first surface (311) of the first substrate (310) through the adhesive member (370) and is in contact with the third surface (321) of the second substrate (320).

15. The electronic device of any one of claims 1 to 14, wherein the heat dissipation member (350) is in contact with an area (321a) of the third surface (321), which overlaps with the first electronic component(E1) when viewed in the direction orthogonal to the fourth surface(322).
